Europäisches Patentamt

European Patent Office

Office européen des brevets

(11) Publication number: **0 029 350**
**B1**

(12) **EUROPEAN PATENT SPECIFICATION**

(45) Date of publication of patent specification: **05.08.87**

(21) Application number: **80304070.8**

(22) Date of filing: **13.11.80**

(51) Int. Cl.⁴: **H 01 L 27/06,** H 03 K 19/088, H 01 L 29/06

(54) **An output transistor of a TTL device with a means for discharging carriers.**

(30) Priority: 14.11.79 JP 147454/79
15.12.79 JP 162959/79
15.12.79 JP 162960/79

(43) Date of publication of application:
27.05.81 Bulletin 81/21

(45) Publication of the grant of the patent:
05.08.87 Bulletin 87/32

(84) Designated Contracting States:
DE FR GB

(56) References cited:
FR-A-2 406 894

IBM TECHNICAL DISCLOSURE BULLETIN,
vol.11, no.11, April 1969, New York (US). W. W.
WU: "Transistor with pull-down resistor"

IEEE JOURNAL OF SOLID STATE CIRCUITS,
vol.14, no.5, October 1979, IEEE. A. HOTTA et
al.: "A pair of bipolar memory LSI chips for
mainframe computers", pages 844-849

(73) Proprietor: FUJITSU LIMITED
1015, Kamikodanaka Nakahara-ku
Kawasaki-shi Kanagawa 211 (JP)

(72) Inventor: Fukuda, Takeshi
c/o Nakae Enomoto 2-41-6, Higashitamagawa
Setagaya-ku Tokyo, 158 (JP)
Inventor: Mitono, Yoshiharu
1-14-12, Sakuragaoka
Setagaya-ku Tokyo, 156 (JP)
Inventor: Kiriseko, Tadashi
3-6-16, Wakabadai Shiroyama-cho
Tsukui-gun Kanagawa, 220-01 (JP)

(74) Representative: Bedggood, Guy Stuart et al
Haseltine Lake & Co. Hazlitt House 28
Southampton Buildings Chancery Lane
London WC2A 1AT (GB)

Courier Press, Leamington Spa, England.

## Description

The present invention relates to an output transistor of a TTL device with a means for discharging carriers.

TTL circuits are widely used for bipolar integrated circuits such as large scale integrated circuits (LSI) or very large scale integrated circuits (VLSI) for example because of their low power dissipation and because their speed of operation is faster than that of diode transistor logic (DTL) circuits. Efforts have been made recently to discharge carriers stored in a base region of an output transistor, of such a TTL circuit, when it is switched from ON state to OFF state.

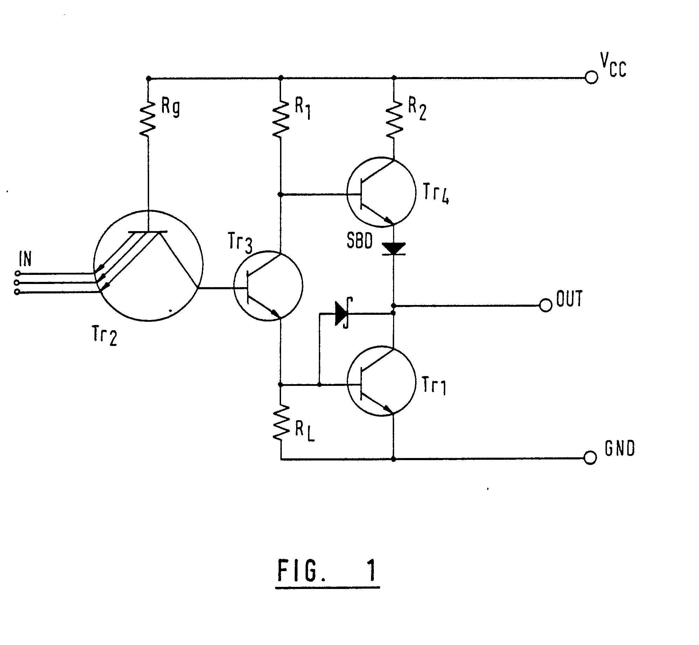

A typical TTL circuit is shown in Figure 1 of the accompanying drawings which is a schematic circuit diagram. An output transistor of the circuit is designated by $Tr_1$, and a multi-emitter input transistor by $Tr_2$. This multi-emitter transistor $Tr_2$ performs the circuit's logic function, with inputs to the circuit being supplied to emitters of transistor $Tr_2$. Resistor $R_L$ shown in Figure 1 is provided for discharging minority carriers stored in the base region of the transistor $Tr_1$ when output is switched from low level to high level, or from ON state to OFF state. This serves to improve the speed of operation when switching from ON to OFF.

On the other hand, it is observed that, in contrast to a case in which the output is switched from low level to high level, in the TTL circuit shown in Figure 1, an operation for turning OFF a transistor $Tr_4$, which is originally ON, when the output is switched from high to low level, is subject to delay. In a transition period when the output changes from high to low level, by virtue of resistor $R_L$ a current flows from a resistor $R_1$ to resistor $R_L$ via a transistor $Tr_3$, which slows down the change of collector voltage of the output transistor from high level to low level. Thus, resistor $R_L$ has a rather adverse effect on speed of switching of the output transistor $Tr_1$ from high level to low level.

It has been proposed to replace resistor $R_L$ of Figure 1 with a transistor or a diode and resistance connected in series in United States Reissue Patent 27804. However, this proposal does not effectively solve the problem described above, and the transfer characteristics at the output level are not significantly improved thereby. Also, the provision of a transistor or a diode and a resistance takes up chip area and involves additional manufacturing steps.

FR—A—2 406 894 discloses a semiconductor device which provides a channel between the base region of a bipolar transistor and a semiconductor substrate in which the transistor is formed. The channel is conductive or non-conductive in dependence upon the relationship between the collector voltage of the transistor and a predetermined voltage apparently determined by the structure of the device. The purpose of the channel is to prevent saturation of the transistor and to limit collector voltage.

IBM TDB, Vol. 11, No. 11, April 1969, page 1439, in an article by W. W. Wu, discloses an input transistor of a monolithic switch circuit, which transistor has a pull down resistor which is provided by a P diffusion between a P base region and a $P^+$ isolation region, with a $N^+$ region overlying the P diffusion to form a dumbell resistance as the said pull-down resistance. The storage of charge in the base is thus prevented by discharging the charge accumulation in the base through the dumbell resistance when the base is not being used.

According to the present invention there is provided an output transistor of a TTL device, the transistor comprising a base region, of a first conductivity type, formed in a collector region, of a second conductivity type, opposite to the first conductivity type, a zone of the first conductivity type, and a diffusion region of the first conductivity type formed between the base region and the said zone, such as to provide an electrical connection between the base region and the said zone, for discharging carriers from the base region, characterised in that the said diffusion region partially replaces the collector region of the transistor and is selectively doped so that the said electrical connection is provided with a selected resistance when the transistor is ON, when the potential of the base region bears a first relationship to (e.g. higher than or lower than) the potential of the collector region, and so that the said electrical connection is pinched off, such as to electrically isolate the base region from the said zone, when the transistor is OFF, when the potential of the base region bears a second relationship to (e.g. lower than or higher than) the potential of the collector region, thereby to improve the speed of operation of the transistor when switching from ON to OFF.

An embodiment of this invention is suitable for performing high speed switching operations, and provides an improved structure for transistor-transistor logic TTL circuits.

In efforts to find a method for extracting base current (discharging carriers stored in the base) at the time of switching of an output transistor of a TTL circuit from ON state to OFF state, the inventors of the present invention theorized as follows: the characteristics required of a circuit or device used to draw out the base current in question are that practically no current is allowed to flow when the base potential is somewhat smaller than ON state potential, but a substantial amount of current is permitted to flow near the ON state potential.

One embodiment of this invention relies on the fact that the inventors have found a way of fabricating a structure provided with a path for a leakage current in a region between the base of an and an isolation diffusion zone provided for a transistor. Such a structure is realized by forming a $p^-$ diffusion in a region covering a part, or the whole, of the region between the base of and the isolation diffusion provided for a transistor. This $p^-$ diffusion has such an impurity concentration that it is pinched off by widening of a depletion layer when collector potential is at high level. When the collector (output) is at low level, however, widening of the depletion layer is small, so that the resistance of the diffusion is small, allowing the base current to be sufficiently discharged.

Another embodiment of this invention provides a structure which, in relation to an output transistor, offers improved switching characteristics (without the provision of a resistor $R_L$ as shown in Figure 1), there being provided, in a region between the base region of an output transistor of a TTL circuit, and a semiconductor substrate (ground side zone) of the circuit, a diffusion which is doped in such a manner that it has the same conductivity sign as the base region but is doped more lightly than the base region.

Thus, such an embodiment of this invention provides a structure in which, in relation to an output transistor of a TTL circuit there is a carrier path between the base of the transistor and ground zone which will turn ON and OFF in correspondence with ON and OFF states of the transistor, and whereby when the transistor is turned OFF from an ON state, carriers stored at the junction are vigorously discharged, thus improving switching speeds.

A further embodiment provides a carrier path between a transistor base and an isolation diffusion zone by means of a first diffusion region, extending between the base and the isolation diffusion zone and of the same conductivity type, with a second diffusion region of the opposite conductivity type over the first region and shorted to the collector.

In still another embodiment, the transistor base is extended up to an isolation diffusion zone of the same conductivity type, with a diffusion region, of the opposite conductivity type, over the base region and shorted to the collector.

Reference is made, by way of example, to the accompanying drawings, in which:—

Figure 1 is a schematic circuit diagram of a typical TTL circuit;

Figure 2A is a plan view of an output transistor of an embodiment of the present invention;

Figures 2B and 2C are respective cross-sectional views taken along lines B—B' and C—C' of Figure 2A respectively;

Figures 3A to 3D are respective cross-sectional views illustrating steps in the manufacture of the transistor device shown in Figure 2A;

Figure 4 is a cross-sectional view of an output transistor of a simplest embodiment of the present invention;

Figures 5 and 6 are cross-sectional and plan views respectively of principal parts of another embodiment of the present invention; and

Figures 7 and 8 are views, similar to those of Figures 5 and 6 respectively, of a further embodiment of this invention.

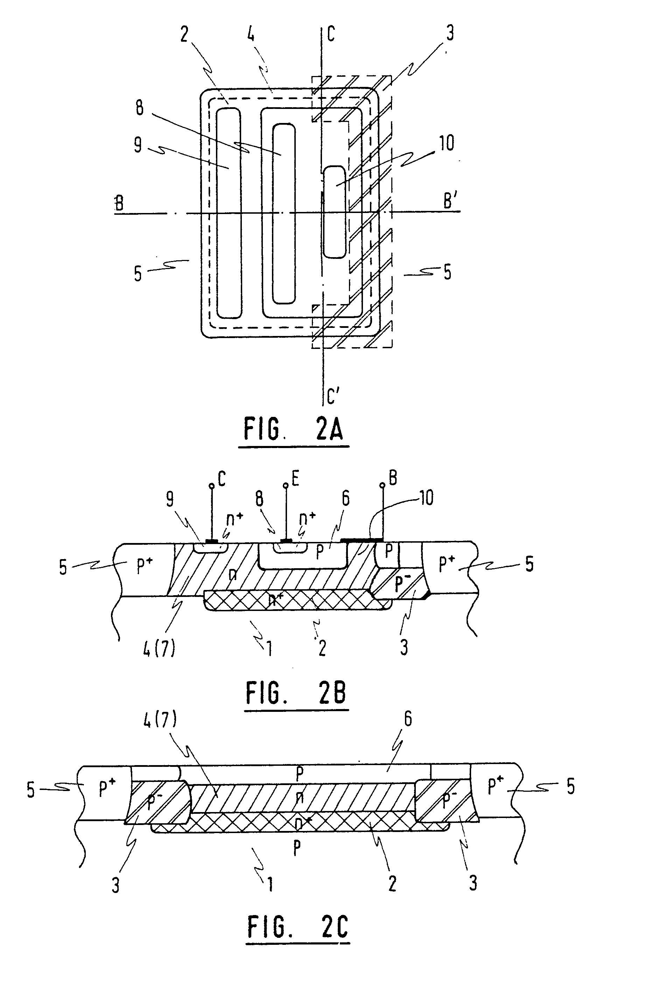

A plan view of an output transistor $Tr_1$ according to one embodiment of the present invention is shown in Figure 2A, with Figure 2B and Figure 2C showing cross-sectional views along the lines B—B' and C—C' of Figure 2A. An $n^+$ layer 2 is buried in a p-type semiconductor substrate 1, and a $p^-$ diffusion 3 is formed. This $p^-$ diffusion 3 connects a $p^+$ isolation diffusion 5 formed in an n-type epitaxial layer 4 and the p-type substrate to a p-type base region 6. A part of conventional collector region referenced (7) is thus replaced by the $p^-$ diffusion 3.

There are formed an $n^+$ emitter region 8 and an $n^+$ collector contact diffusion 9, and a hollow part 10 within the base region 6 is a Shottky barrier diode SBD (which is shown in Figure 1) which serves the purpose of speeding up the switching operation when the output changes from low level to high level as is the case with resistor $R_L$ of Figure 1.

As will be apparent from Figures 2A to 2C, $p^-$ diffusion 3 is interposed between the p-type semiconductor substrate 1, the ground site, $p^+$ isolation diffusion 5 and p-type base region 6. When the output transistor $Tr_1$ is ON, $p^-$ diffusion 3 functions as a resistance conductor from the base to ground, and when the transistor $Tr_1$ is switched from ON to OFF (the output from low level to high level), carriers stored in the base region are caused to be discharged quickly through the $p^-$ diffusion 3. This contributes to a high speed switching operation.

When the transistor $Tr_1$ is in an OFF state, the electrical potential of the collector region 4 is raised, so that the depletion layer widens in $p^-$ diffusion 3 to pinch off the channel provided by diffusion 3, preventing the flow of current. Because of this, when switching from OFF to ON, until the base current of $Tr_3$ is supplied enough, no current flows through the resistor $R_1$. The base potential of $Tr_4$, therefore, changes sharply and the output voltage also changes sharply. Therefore, $p^-$ diffusion 3 which partially replaces the collector region of transistor $Tr_1$ serves to expedite high speed switching operation when the output is switched from low level (ON) to high level (OFF), and when the output is switched from high level to low level, $p^-$ diffusion 3 performs no function. Thus, in such a device embodying the present invention, switching characteristics are further improved compared with a TTL circuit having a resistor $R_L$ as shown in Figure 1.

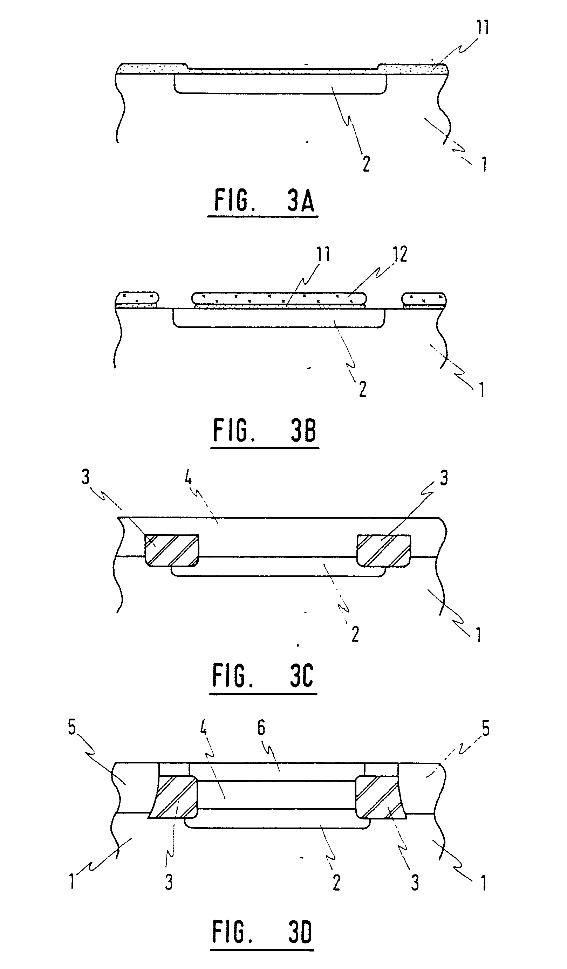

A method of manufacturing the embodiment of the invention described above will now be described with reference to Figures 3A to 3D which show respective steps in the method.

First, as shown in Figure 3A, an oxidized film 11 is formed on a p-type semiconductor substrate 1 by heat treatment at high temperature; a window is opened in the film 11, by a known photolithographic process, for fabricating a buried layer 2 by diffusion of antimony (Sb) or arsenic (As). In this process, oxide film 11 is reformed on the surface of buried layer 2 since the diffusion process is effected at high temperature.

Next, as shown in Figure 3B, a photolithographic process is again effected to open windows at places where p$^-$ diffusions are to be formed, and suitable amounts of boron ions are implanted with a photoresist film 12 used in the process left as it is.

Then, as shown in Figure 3C, the photoresist film 12 is completely removed, and the oxide film 11 is also removed using a solution of fluoric acid. Thereafter, epitaxial layer 4 is grown by a conventional vapour phase deposition. In this process, p$^-$ diffusions 3 are diffused upwardly within the epitaxial layer 4 as shown because the diffusion coefficient of boron is large. The buried layer 2 is also diffused upwardly, but since the diffusion coefficient of antimony or arsenic is smaller than that of boron, the buried layer 2 is diffused less than p$^-$ diffusions 3.

Further, p$^+$ isolation diffusions 5 are formed as shown in Figure 3D, and p-type base region 6 is also formed, both by conventional diffusion process. p$^-$ diffusions 3 are in contact with the base region 6 and isolation diffusions 5.

After these processes are completed, the transistor-transistor logic TTL circuit is further fabricated in accordance with prior art technology.

It will be understood from the foregoing description that p$^-$ diffusions 3 of an output transistor (Tr$_1$ of Figure 1 for example) can easily be formed by implantation of boron ions before formation of epitaxial layer 4. This process of ion implantation as described above is the only process that is added to the prior art method of TTL fabrication. No other changes nor any other additions are required to manufacture the semiconductor device embodying the present invention described above.

As will be understood from the foregoing description, no special resistance such as resistance R$_L$ shown in Figure 1 is required in the embodiment of this invention described above. By providing within a transistor a region, such as the p$^-$ diffusion described above, diffused lightly with impurities which has the effect of improving switching speed, characteristics of a TTL circuit can be greatly improved.

The resistance R$_L$ of the Figure 1 proposal must be formed separately, and to do so takes up chip area. Such a proposal is not in line with the recent trend towards increased packing density for integrated circuits.

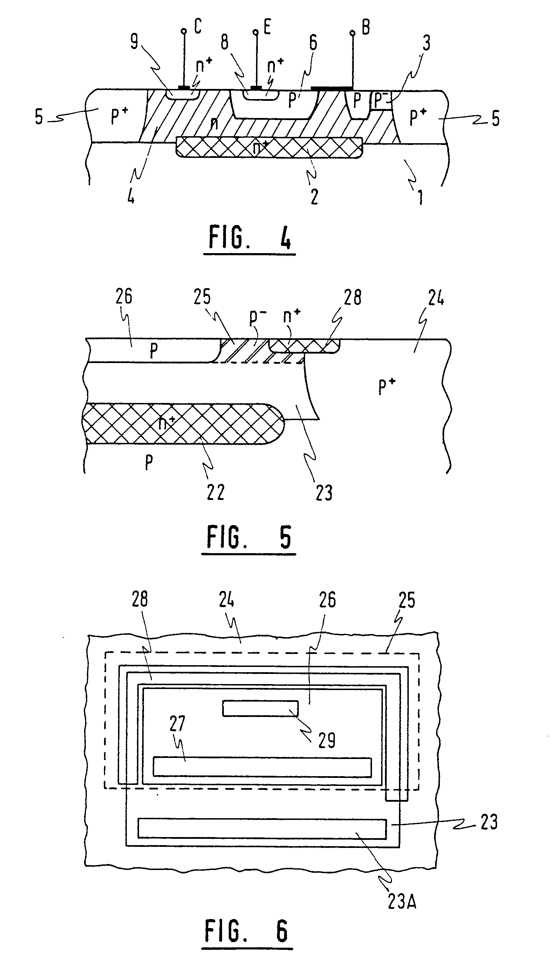

A further, simpler, embodiment of the present invention shown in Figure 4. In Figure 4 the same reference numerals as in Figures 2B and 2C are used.

It will be seen that in the embodiment of Figure 4, p$^-$ diffusion 3 connects base 6 and isolation diffusion 5.

The p$^-$ diffusion 3 is formed after formation of epitaxial layer 4.

Here, a quantitative review will be made to determine whether or not desired characteristics can be obtained by the structure of Figure 4.

Assuming a step junction between p$^-$ diffusion 3 and collector region 4 the depth to which the depletion layer extends into the p$^-$ diffusion is given as follows (considering $N_A = N_D$)

$$X_p = \frac{1}{2} \sqrt{\frac{2k_s\varepsilon_o}{q} \cdot \frac{N_A + N_D}{N_A N_D}} \cdot \phi_T$$

where $N_A$ is acceptor concentration in diffusion 3, $N_D$ is donor concentration in region 4, q is the electronic charge, $\varepsilon_o$ is the permittivity of free space, $k_s$ is the relative permittivity of the material of the device of Figure 4 (e.g. silicon), and $\phi_T$ is the potential across the junction.

Taking a case in which $N_A = 1.5 \times 10^{16}/cm^3$, and also considering that $\phi_B = 0.7V$, $V_{OL} = 0.4V$ and $V_{OH} = 2.5V$, (where $\phi_B$ is built-in potential across the junction $V_{OL}$ is collector potential when the transistor is ON, and $V_{OH}$ is collector potential when the transistor is OFF), $X_p$ when $\phi_T = (0.7 + 2.5)V = 3.2V$ is

$$X_p = \frac{1}{2} \sqrt{2 \times 6.52 \times 10^6 \times \frac{3 \times 10^{16}}{1.5 \times 1.5 \times 10^{32}} \times 3.2} = 0.373 \ \mu m$$

And $X_p$ when $\phi_T = (0.7 + 0.4)V = 1.1V$ is $X_p = 0.219 \ \mu m$.

Thus, $(0.373 - 0.219) \ \mu m = 0.154 \ \mu m$ is the change in width of depletion layer between OFF and ON states.

$N_A = 1.5 \times 10^{16}/cm^3$ gives $\rho = 1.0 \ \Omega \cdot cm$ ($\rho$ specific resistance or resistivity of diffusion 3). The resistance between the base region and isolation diffusion at $V_{OL}$ is given by

$$R = 1.0 \times \frac{L}{0.154 \cdot w} \times 10^4 = 6.49 \times 10^4 \times \left(\frac{L}{w}\right)$$

where L is the distance between the base region and the isolation diffusion, w is the length along the periphery of the base, and 0.154 $\mu m$ is free width of region 3 when the transistor is ON.

In order to obtain $R = 3K\Omega$,

4

$$\frac{L}{w}$$

must be equal to $4.62 \times 10^{-2}$. This is the case when $L=3$ μm, $w \simeq 65$ μm.

The amount Q of impurities to be deposited in region 3 is:—

$$Q = 1.5 \times 10^{-16} \times 0.373 \times 10^{-4} \simeq 5.6 \times 10^{11}/cm^2.$$

From the above, it will be understood that, by properly selecting dosage, sufficient resistance may be obtained by conventional techniques for manufacturing integrated circuits.

The basis for the above conclusion is as follows:—

(1) Amount of impurities $Q_o$ (the dose required in ion implantation) may be obtained from the condition for pinch off of the path between base 6 and isolation diffusion 5 provided by $p^-$ diffusion 3.

$$X_p = \frac{N_D}{N_A + N_D} \sqrt{\frac{2k_s\varepsilon_o}{q} \cdot \frac{N_A + N_D}{N_A \cdot N_D} \cdot (\phi_B + V_{OH})}$$

$$Q_o = N_A X_p = \frac{N_A \cdot N_D}{N_A + N_D} \sqrt{\frac{2k_s\varepsilon_o}{q} \cdot \frac{N_A + N_D}{N_A \cdot N_D} \cdot (\phi_B + V_{OH})}$$

$$= \sqrt{\frac{2k_s\varepsilon_o}{q} \cdot \frac{N_A \cdot N_D}{N_A + N_D} \cdot (\phi_B + V_{OH})}$$

Where the collector potential is at V rather than $V_{OH}$, the amount of carriers is

$$Q_o - \sqrt{\frac{2k_s\varepsilon_o}{q} \cdot \frac{N_A \cdot N_D}{N_A + N_D} \cdot (\phi_B + V)}$$

Considering that

$$\rho_s = \frac{1}{q\mu Q}, \qquad R = \rho_s \frac{L}{w}$$

where $\rho_s$ is the specific resistance or resistivity of region 3, q is the electronic charge and μ is carrier mobility in region 3, R, the resistance offered by region 3, depends on V as follows:

$$R = \frac{1}{q\mu \left( Q_o - \sqrt{\frac{2k_s\varepsilon_o}{q} \cdot \frac{N_A \cdot N_D}{N_A + N_D} \cdot (\phi_B + V)} \right)} \cdot \frac{L}{w}$$

Reference will now be made to Figure 5 which shows in cross-section principal parts of another embodiment of this invention and to Figure 6 which shows the parts of Figure 5 in plan view.

In these Figures, $n^+$ buried layer 22 is formed in a p-type silicon substrate 21, and n-type collector region 23, $p^+$ isolation diffusion 24, $p^-$ diffusion 25, p-type base region 26, $n^+$ emitter region 27, $n^+$ diffusion 28, Shottky barrier diode (SBD) region 29, and collector contact diffusion 23A are fabricated in accordance with known techniques. The $n^+$ diffusion 28 is shorted to collector region 23.

In this embodiment, when collector region 23 and consequently $n^+$ diffusion 28 are at high level and base region 26 at low level, that is, when the transistor is about to be turned ON, the depletion layer extends from a first p-n junction formed by the collector region 23 and $p^-$ diffusion 25 and a second p-n junction formed by the $p^-$ diffusion 25 and $n^+$ diffusion 28 respectively to pinch off the region between the base region 26 and isolation diffusion 24. Whereupon, the device shown effectively performs the function of a transistor. Conversely, when the collector region 23 and consequently $n^+$ diffusion 28 are at low level and the base region 26 at high level, that is, when the transistor is about to be turned OFF, the depletion layer virtually does not extend from either the first p-n junction or the second p-n junction. Thus, since the base region 26 and isolation diffusion 24 are interconnected, stored carriers are discharged quickly.

Instead of forming $n^+$ diffusion 28 as seen in the above embodiment, the carrier discharge channel may be pinched off by a depletion layer extending from a p-n junction formed by collector region 23 and $p^-$

diffusion 25, but in such a case, it is inevitable that a carrier path established between the base region 26 and isolation diffusion 24 when the collector region 23 is at low level is only approximately 1/2 of that obtained in the simplest embodiment of the invention shown in Figure 4 assuming that surface area of the p⁻ diffusion 25 is the same. It will be apparent further than n⁺ diffusion 28 may be formed so as to cover the entire surface of the p⁻ diffusion 25.

As will be understood from the foregoing description of the Figure 5 embodiment of the present invention, in an output transistor of a TTL circuit there are formed between the base region and isolation diffusion a first region diffused with impurities of the same conductivity sign as, and of less concentration than, that of the base region and isolation diffusion, and a second region diffused with impurities of the same conductivity sign as that of the collector region. The second region covers at least a part of the first region and is interconnected with the collector region. Thus, when the transistor is OFF, the region between the base and isolation diffusion is pinched off by widening of the depletion layer, and when the transistor is in an ON state, the depletion layer is not widened, the carrier passage between the base region and isolation diffusion is opened to discharge carriers stored while the transistor is ON. This improves the switching speed of the semiconductor device. Conventional photolithographic processes and processes for diffusion of impurities are used in fabricating the device described above, and no particular difficulties are experienced in such fabrication.

It will be recalled that in an embodiment of the present invention relating to a TTL circuit as shown in Figure 1, a carrier passage which turns ON and OFF corresponding to ON and OFF states of the transistor can be established between the base region and ground, when the transistor is turned OFF from the ON state, carriers stored at the junction being caused to be discharged hard on to improve the switching speed of the device.

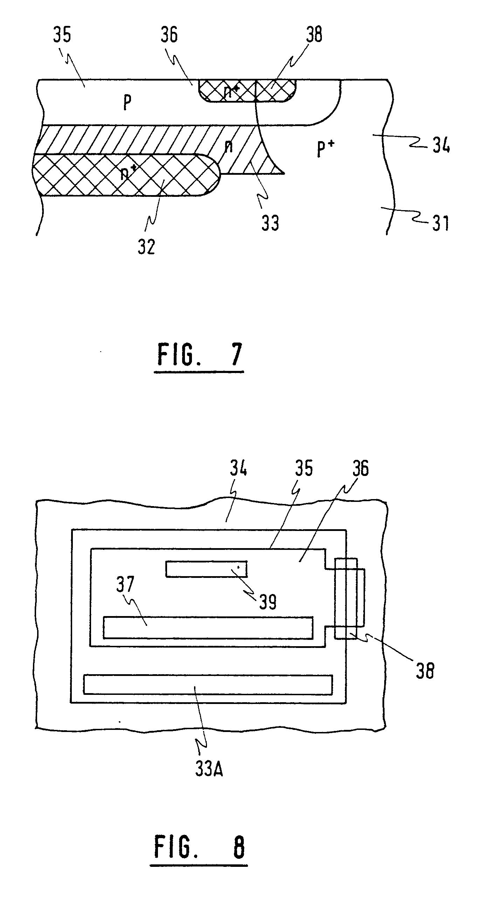

Referring to Figures 7 and 8 which show essential parts of another embodiment of the present invention in cross-section and plan view respectively, n⁺ buried layer 32 is formed in a p-type silicon substrate 31, and n-type collector region 33, p⁺ isolation diffusion 34, p-type base region 35, p-type extension region 36 of the base region, n⁺ emitter region 37, n⁺ diffusion 38, Shottky barrier diode (SBD) region 39 and collector-contact diffusion 33A are formed by conventional techniques. The n⁺ diffusion 38 is shorted to the collector region 33.

In this embodiment, when the collector region 33 and consequently n⁺ diffusion 38 are at high level and the base region 35 at low level, that is, when the transistor is about to be turned ON, depletion layers extend from both a first p-n junction formed by the collector region 33 and the p-type extension region 36 of the base region and a second p-n junction formed by the p-type extension region 36 of the base region and the n⁺ diffusion 38 to pinch off the region between the base region 35 and isolation diffusion 34. Whereupon, the device can effectively perform the operations of a transistor. Conversely, when the collector region 33 and consequently n⁺ diffusion 38 are at low level and the base region 35 at high level, that is, when the transistor is about to be turned OFF, the depletion layers from the above described first and second junctions practically do not widen, so that the region between the base region 35 and the isolation diffusion remains interconnected. Stored carriers are quickly discharged.

The n⁺ diffusion 38 of this embodiment need not be placed in the position shown in the drawing. What is important is that it is situated between the base region 35 as extended to the isolation diffusion 34 and the isolation diffusion 34 so that the depletion layers are extended therebetween for pinch off.

As will be understood from the foregoing description, the embodiment of Figures 7 and 8 provides, in an output transistor of a TTL circuit, that the base region is extended to make contact with the isolation diffusion, that a diffusion layer of the same conductivity sign as the collector region and which is interconnected to the collector region is situated therebetween. When the transistor is OFF depletion layers are extended between the base region and isolation diffusion to cause pinch off, and when the transistor is ON the depletion layers are not widened, allowing carrier passage to be opened between the base region and isolation diffusion to discharge quickly carriers stored while the trnasistor is ON. The switching speed of the semiconductor device is thus improved. In order to fabricate such a device, conventional photolithographic processes and doping processes are utilized, and no particular difficulties are experienced.

As has been described so far, the present invention affords a simple means of improving the switching speed of a TTL semiconductor device which can be manufactured without any particular difficulties using conventional technology.

In an output transistor of a transistor-transistor logic (TTL) circuit for example, an output transistor is provided, in a region between a p-type base region and a p-type semiconductor substrate on which the TTL circuit is fabricated, with a p⁻ diffusion which causes carriers stored in the base region to be discharged quickly when the output transistor is switched from ON state to OFF state. When the output transistor is OFF, the p⁻ diffusion is pinched off and no current flows. Thus, when the output transistor is switched from OFF state to ON state, output voltage changes sharply. Thereby, switching speed is improved.

In another embodiment, a p⁻ region is formed between a p-type base region and p⁺ isolation diffusion.

An n⁺ diffusion may be formed to cover at least one part of the p⁻ diffusion and to be connected to an n-type collector region.

In a further embodiment, a p-type base region extends up to a p⁺ isolation diffusion, and an n⁺ diffusion is formed in a region between the base region and isolation diffusion and is connected to an n-type collector region.

**Claims**

1. An output transistor of a TTL device, the transistor comprising a base region (6, 26, 35), of a first conductivity type, formed in a collector region (4, 23, 33), of a second conductivity type, opposite to the first conductivity type, a zone (1, 5, 24, 34) of the first conductivity type, and a diffusion region (3, 25, 36) of the first conductivity type formed between the base region (6, 26, 35) and the said zone (1, 5, 24, 34), such as to provide an electrical connection between the base region (6, 26, 35) and the said zone (1, 5, 24, 34), for discharging carriers from the base region (6, 26, 35), characterised in that the said diffusion region (3, 25, 36) partially replaces the collector region (4) of the transistor and is selectively doped so that the said electrical connection is provided with a selected resistance when the transistor is ON, when the potential of the base region (6, 26, 35) bears a first relationship to (e.g. higher than or lower than) the potential of the collector region (4, 23, 33), and so that the said electrical connection is pinched off, such as to electrically isolate the base region (6, 26, 35) from the said zone (1, 5, 24, 34), when the transistor is OFF, when the potential of the base region (6, 26, 35) bears a second relationship to (e.g. lower than or higher than) the potential of the collector (4, 23, 33), thereby to improve the speed of operation of the transistor when switching from ON to OFF.

2. A device as claimed in claim 1, wherein the zone of the first conductivity type is provided by a semiconductor substrate (1) of the device.

3. A device as claimed in claim 1, wherein the said zone of the first conductivity type is an isolation diffusion zone (5, 24, 34).

4. A device as claimed in claim 3, wherein the said diffusion region (36) is provided by an extension of the base region (35) to the isolation diffusion zone (34).

5. A device as claimed in claim 1, 2 or 3, wherein the said diffusion region (3, 25) is more lightly doped than the base region (6, 26).

6. A device as claimed in claim 5 when read as appended to claim 3, wherein the said diffusion region (3) is free from any overlying region of the second conductivity type.

7. A device as claimed in claim 4, or as claimed in claim 5 when read as appended to claim 3, wherein another diffusion region (28, 38), of the second conductivity type, is formed within the said diffusion region (25, 36).

8. A device as claimed in any preceding claim, wherein the first conductivity type is p-type, and the second conductivity type n-type.

9. A device as claimed in claim 8 when read as appended to claim 7, wherein the diffusion region of the second conductivity type is an $n^+$ region.

**Patentansprüche**

1. Ausgangstransistor einer TTL-Vorrichtung, welcher Transistor umfaßt, einen Basisbereich (6, 26, 35) von einem ersten Leitfähigkeitstyp, der in einem Kollektorbereich (4, 23, 33) von einem zweiten Leitfähigkeitstyp gebildet ist, der entgegengesetzt zu dem ersten Leitfähigkeitstyp ist, eine Zone (1, 5, 24, 34) von dem ersten Leitfähigkeitstyp, und einen Diffusionsbereich (3, 25, 36) von dem ersten Leitfähigkeitstyp, der zwischen dem Basisbereich (6, 26, 35) und der genannten Zone (1, 5, 24, 34) gebildet ist, um so eine elektrische Verbindung zwischen dem Basisbereich (6, 26, 35) und der genannten Zone (1, 5, 24, 34) zu bilden, zur Entlandung von Trägern aus dem Basisbereich (6, 26, 35), dadurch gekennzeichnet, daß der genannte Diffusionsbereich (3, 25, 36) teilweise den Kollektorbereich (4) des Transistors ersetzt und selektiv so dotiert ist, daß die genannte elektrische Verbindung mit einem ausgewählten Widerstand vorgesehen ist, wenn der Transistor AN ist, wenn das Potential des Basisbereiches (6, 26, 35) eine erste Relation (z.B. höher oder niedriger als) zu dem Potential des Kollektorbereiches (4, 23, 33) aufweist, und so, daß die elektrische Verbindung abgeschnürt ist, um so den Basisbereich (6, 26, 35) von der genannten Zone (1, 5, 24, 34) elektrisch zu isolieren, wenn der Transistor AUS ist, wenn das Potential des Basisbereiches (6, 26, 35) eine zweite Relation (z.B. niedriger oder höher als) zu dem Potential des Kollektors (4, 23, 33) aufweist, um dadurch die Betriebsgeschwindigkeit des Transistors beim Schalten von AN nach AUS zu erhöhen.

2. Vorrichtung nach Anspruch 1, bei der die Zone von dem ersten Leitfähigkeitstyp durch ein Halbleitersubstrat (1) der Vorrichtung gebildet ist.

3. Vorrichtung nach Anspruch 1, bei der die genannte Zone von dem ersten Leitfähigkeitstyp eine Isolationsdiffusionszone (5, 24, 34) ist.

4. Vorrichtung nach Anspruch 3, bei der der genannte Diffusionsbereich (36) durch eine Verlängerung des Basisbereiches (35) zu der Isolationsdiffusionszone (34) gebildet ist.

5. Vorrichtung nach Anspruch 1, 2 oder 3, bei der der genannte Diffusionsbereich (3, 25) leichter als der genannte Basisbereich (6, 26) dotiert ist.

6. Vorrichtung nach Anspruch 5, in Verbindung mit Anspruch 3, bei der der genannte Diffusionsbereich (3) frei von irgendeinem darüberliegenden Bereich von dem zweiten Leitfähigkeitstyp ist.

7. Vorrichtung nach Anspruch 4, oder nach Anspruch 5 in Verbindung mit Anspruch 3, bei der ein anderer Diffusionsbereich (28, 38), von dem zweiten Leitfähigkeitstyp, innerhalb des genannten Diffusionsbereiches (25, 36) gebildet ist.

8. Vorrichtung nach einem der vorhergehenden Ansprüche, bei der der genannte erste Leitfähigkeitstyp der p-Typ und der genannte zweite Leitfähigkeitstyp der n-Typ ist.

9. Vorrichtung nach Anspruch 8, in Verbindung mit Anspruch 7, bei der der Diffusionsbereich von dem zweiten Leitfähigkeitstyp ein $n^+$-Bereich ist.

**Revendications**

1. Transistor de sortie d'un dispositif TTL, le transistor comportant une région de base (6, 26, 35) d'un premier type de conductivité, formée dans une région de collecteur (4, 23, 33) d'un second type de conductivité opposé au premier type de conductivité, une zone (1, 5, 24, 34) du premier type de conductivité et une région de diffusion (3, 25, 36) du premier type de conductivité formée entre la région de base (6, 26, 35) et ladite zone (1, 5, 24, 34), de manière à établir une connexion électrique entre la région de base (6, 26, 35) et ladite zone (1, 5, 24, 34) afin de décharger des porteurs de la région de base (6, 26, 35), caractérisé en ce que ladite région de diffusion (3, 25, 36) remplace partiellement la région de collecteur (4) du transistor et est dopée sélectivement de manière que ladite connexion électrique soit établie avec une résistance sélectionnée quand le transistor est débloqué, quand le potentiel de la région de base (6, 26, 35) répond à une première relation avec (par exemple supérieure ou inférieure) le potentiel de la région de collecteur (4, 23, 33) et que ladite connexion électrique soit pincée, afin d'isoler électriquement la région de base (6, 26, 35) de ladite zone (1, 5, 24, 34) quand le transistor est bloqué, lorsque le potentiel de la région de base (6, 26, 35) répond à une seconde relation avec (par exemple inférieure ou supérieure) le potentiel du collecteur (4, 23, 33), en améliorant ainsi la vitesse de fonctionnement du transistor au passage de l'état débloqué à l'état bloqué.

2. Dispositif selon la revendication 1, dans lequel la zone du premier type de conductivité est constituée par un substrat semi-conducteur (1) du dispositif.

3. Dispositif selon la revendication 1, dans lequel ladite zone du premier type de conductivité est une zone de diffusion d'isolement (5, 24, 34).

4. Dispositif selon la revendication 3, dans lequel ladite région de diffusion (36) est constituée par un prolongement de la région de base (35) vers la zone de diffusion d'isolement (34).

5. Dispositif selon la revendication 1, 2, ou 3, dans lequel ladite région de diffusion (3, 25) est plus légèrement dopée que la région de base (6, 26).

6. Dispositif selon la revendication 5, vue comme annexée à la revendication 3, dans lequel ladite région de diffusion (3) est exempte de toute région superposée du second type de conductivité.

7. Dispositif selon la revendication 4 ou la revendication 5, vue annexée à la revendication 3, dans lequel une autre région de diffusion (28, 38) du second type de conductivité est formée dans ladite région de diffusion (25, 36).

8. Dispositif selon l'une quelconque des revendications précédentes, dans lequel le premier type de conductivité est le type P et le second type de conductivité le type N.

9. Dispositif selon la revendication 8, vue annexée à la revendication 7, dans lequel la région de diffusion du second type de conductivité est une région $N^+$.

FIG. 1

0 029 350

FIG. 2A

FIG. 2B

FIG. 2C

2

FIG. 3A

FIG. 3B

FIG. 3C

FIG. 3D

FIG. 4

FIG. 5

FIG. 6

FIG.  7

FIG.  8